# EUROPEAN PATENT APPLICATION

(11) **EP 4 611 180 A1**
(43) Date of publication of application: **03.09.2025**
(21) Application number: 25155496.0
(22) Date of filing: 03.02.2025
(51) Int. Cl.: H01R 12/69, H01R 12/70, H01R 12/77

(54) **CONNECTOR**

(30) Priority: 29.02.2024 JP 2024030407
(71) Applicant: Japan Aviation Electronics Industry, Limited, Tokyo 150-0043 (JP)
(72) Inventor: MATSUO, Seiya, Tokyo, 150-0043 (JP)
(74) Representative: Qip Patent & Recht Dr. Kuehn & Partner mbB

(57) **Abstract**

A connector includes an electrically-conductive plug contact, a bottom insulator and an electrically-conductive inner contact, the plug contact having a tubular portion extending along a fitting axis with a recessed portion in an interior thereof and a flange extending from an end portion of the tubular portion, the bottom insulator having a support surface and a projection projecting from the support surface along the fitting axis and press-fitted in the recessed portion, the electrically-conductive inner contact being disposed on the support surface, the inner contact including a retention portion retained in the recessed portion and contacting an inner surface of the recessed portion and an elastic portion joined to the retention portion to face a back surface of the flange and having a cantilever shape elastically deformable in a direction along the fitting axis.

## Description

### BACKGROUND OF THE INVENTION

The present invention relates to a connector, particularly to a connector connected to a sheet type connection object having a conductor exposed on at least one surface of the connection object.

In recent years, attention has been drawn to so-called smart clothes that can obtain user's biological data such as the heart rate and the body temperature only by being worn by the user. Such smart clothes have an electrode disposed at a measurement site, and when a wearable device serving as a measurement device is electrically connected to the electrode, biological data can be transmitted to the wearable device.

The electrode and the wearable device can be interconnected by, for instance, use of a connector connected to a conductor drawn from the electrode.

As a connector of this type, for example, JP 2018-129244 A discloses a connector shown in FIG. 26. This connector includes a housing 2 and a base member 3 that are separately disposed on the opposite sides of a flexible substrate 1 to sandwich the flexible substrate 1. Tubular portions 4A of contacts 4 are passed through contact through-holes 2A of the housing 2, and flanges 4B of the contacts 4 are sandwiched between the housing 2 and conductors 1A exposed on the front surface of the flexible substrate 1.

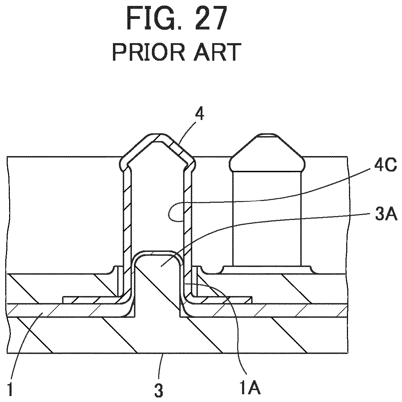

In this state, when the base member 3 is pushed toward the housing 2, as shown in FIG. 27, a projection 3A of the base member 3 is inserted into a projection accommodating portion 4C of the contact 4 with the flexible substrate 1 being sandwiched therebetween, and the inner surface of the projection accommodating portion 4C makes contact with the conductor 1A with a predetermined contact force, whereby the contact 4 is electrically connected to the conductor 1A.

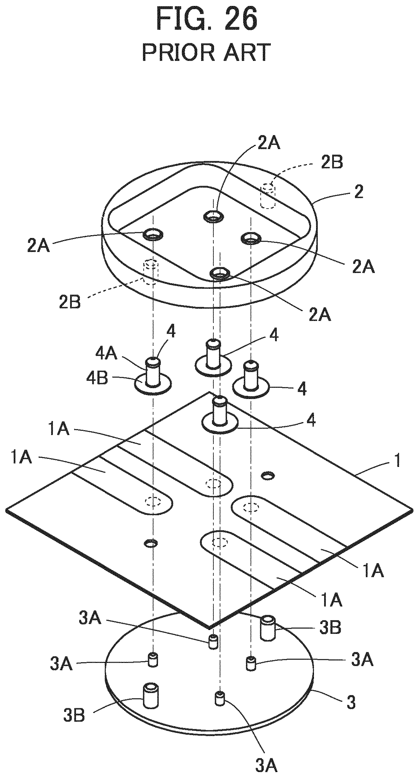

In addition, housing fixing posts 3B formed to project on the base member 3 are press-fitted into post accommodating portions 2B of the housing 2 as shown in FIG. 26, so that the housing 2 and the base member 3 are fixed to each other.

When fitted with the connector disclosed in JP 2018-129244 A, a wearable device can be connected to electrodes formed of the conductors.

However, when the conductors 1A are exposed only on the back surface of the flexible substrate 1, the connector of JP 2018-129244 A is useless for electrically connecting the conductors 1A to the contacts 4, disadvantageously.

### SUMMARY OF THE INVENTION

The present invention has been made to solve the foregoing problem and aims at providing a connector that enables an electrical connection of a contact to a conductor of a connection object regardless of whether the conductor is exposed on the front surface or the back surface of the connection object.

A connector according to the present invention comprises:
a plug contact having electric conductivity and including a tubular portion and a flange, the tubular portion extending along a fitting axis and being provided in its interior with a recessed portion, and the flange extending from an end portion of the tubular portion in a direction orthogonal to the fitting axis;
a bottom insulator including a support surface and a projection, the support surface extending in the direction orthogonal to the fitting axis, and the projection projecting from the support surface along the fitting axis and being press-fitted in the recessed portion; and
an inner contact having electric conductivity and being disposed on the support surface, part of the inner contact being inserted in the recessed portion,
wherein the inner contact includes a retention portion and an elastic portion, the retention portion being retained in the recessed portion and making contact with an inner surface of the recessed portion to be electrically connected to the plug contact, and the elastic portion being joined to the retention portion to face a back surface of the flange and having a cantilever shape that is elastically deformable in a direction along the fitting axis,
when the projection is press-fitted in the recessed portion, the plug contact is fixed to the bottom insulator, and
part of a connection object of sheet shape having a conductor exposed on at least one surface of the connection object is sandwiched between the back surface of the flange of the plug contact and the elastic portion of the inner contact in a direction along the fitting axis, the back surface of the flange makes contact with a front surface of the connection object, and the elastic portion makes contact with a back surface of the connection object, whereby the plug contact is electrically connected to the conductor directly when the conductor is exposed on the front surface of the connection object, and the plug contact is electrically connected to the conductor via the inner contact when the conductor is exposed on the back surface of the connection object.

### BRIEF DESCRIPTION OF THE DRAWINGS

FIG. 1 is a perspective view of a connector according to an embodiment, when viewed from an obliquely upper position.
FIG. 2 is an assembly view of the connector according to the embodiment.
FIG. 3 is a perspective view showing a top insulator used in the connector of the embodiment.
FIG. 4 is a perspective view showing a plug contact used in the connector of the embodiment.
FIG. 5 is a cross-sectional view showing the plug contact used in the connector of the embodiment.
FIG. 6 is a perspective view showing a bottom insulator used in the connector of the embodiment.
FIG. 7 is a perspective view showing a projection of the bottom insulator used in the connector of the embodiment.
FIG. 8 is a plan view showing the projection of the bottom insulator used in the connector of the embodiment.
FIG. 9 is a perspective view of an inner contact used in the connector of the embodiment, when viewed obliquely from the front.
FIG. 10 is a perspective view of the inner contact used in the connector of the embodiment, when viewed obliquely from the rear.
FIG. 11 is a front view showing the inner contact used in the connector of the embodiment.
FIG. 12 is a perspective view of a connection object to be connected to the connector of the embodiment, when viewed from an obliquely upper position.
FIG. 13 is a perspective view of the connection object to be connected to the connector of the embodiment, when viewed from an obliquely lower position.
FIG. 14 is a perspective view showing a reinforcement sheet used in the connector of the embodiment.
FIG. 15 is a cross-sectional front view showing the state where the inner contact is aligned with the bottom insulator in the embodiment.
FIG. 16 is a perspective view showing the state where the inner contact is disposed in the bottom insulator in the embodiment.
FIG. 17 is a cross-sectional front view showing the state where the inner contact is disposed in the bottom insulator in the embodiment.
FIG. 18 is a plan view showing the state where the inner contact is disposed in the bottom insulator in the embodiment.
FIG. 19 is a cross-sectional front view showing the state where the connection object is disposed above the bottom insulator and the plug contact is aligned with the bottom insulator in the embodiment.
FIG. 20 is a cross-sectional front view showing the state where the projection of the bottom insulator is in the process of being press-fitted into the plug contact in the embodiment.
FIG. 21 is a cross-sectional front view showing a press-fitting completion state of the projection of the bottom insulator with respect to the plug contact in the embodiment.
FIG. 22 is a cross-sectional side view showing the press-fitting completion state of the projection of the bottom insulator with respect to the plug contact in the embodiment.
FIG. 23 is a perspective view of the connector of the embodiment connected to the connection object, when viewed from an obliquely lower position.
FIG. 24 is a cross-sectional front view partially showing the state of the interior of the plug contact in the connector of the embodiment connected to the connection object.
FIG. 25 is a cross-sectional side view partially showing the state of the interior of the plug contact in the connector of the embodiment connected to the connection object.
FIG. 26 is an exploded perspective view showing a conventional connector.
FIG. 27 is a partial cross-sectional view showing the conventional connector.

### DETAILED DESCRIPTION OF THE INVENTION

An embodiment of the present invention is described below based on the accompanying drawings.

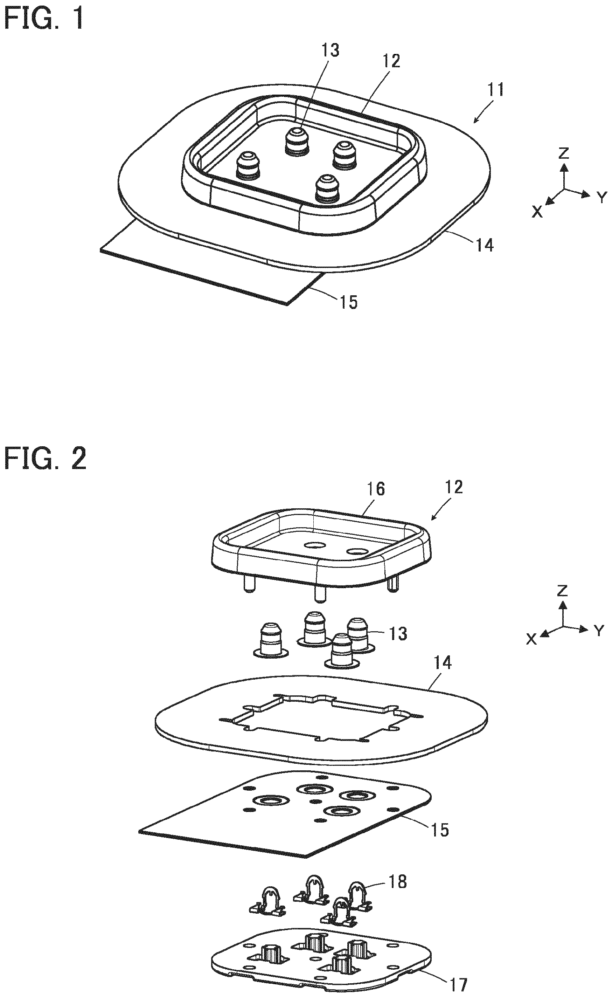

FIG. 1 shows a connector 11 according to the embodiment. The connector 11 is used as, for instance, a garment-side connector for fitting a wearable device and has a housing 12 made of an insulating material. In the housing 12, four plug contacts 13 are retained, and a reinforcement sheet 14 and a sheet type conductive member 15 being superposed on each other are retained by the housing 12. The sheet type conductive member 15 constitutes a connection object to which the contact 11 is connected.

The four plug contacts 13 are aligned in two rows parallel to each other and disposed to project perpendicularly with respect to the sheet type conductive member 15.

For convenience, the reinforcement sheet 14 and the sheet type conductive member 15 are defined as extending along an XY plane, the alignment direction of the four plug contacts 13 is referred to as "Y direction," and the direction in which the four plug contacts 13 project is referred to as "+Z direction." The Z direction is a fitting direction in which the connector 11 is fitted to a counter connector.

FIG. 2 shows an exploded perspective view of the connector 11. The connector 11 includes a top insulator 16 and a bottom insulator 17, and these top and bottom insulators 16 and 17 constitute the housing 12.

The four plug contacts 13 are disposed on the -Z direction side of the top insulator 16, the reinforcement sheet 14 is disposed on the -Z direction side of the plug contacts 13, and the sheet type conductive member 15 is disposed on the -Z direction side of the reinforcement sheet 14. Further, four inner contacts 18 are disposed on the -Z direction side of the sheet type conductive member 15, and the bottom insulator 17 is disposed on the -Z direction side of the inner contacts 18. The four inner contacts 18 separately correspond to the four plug contacts 13.

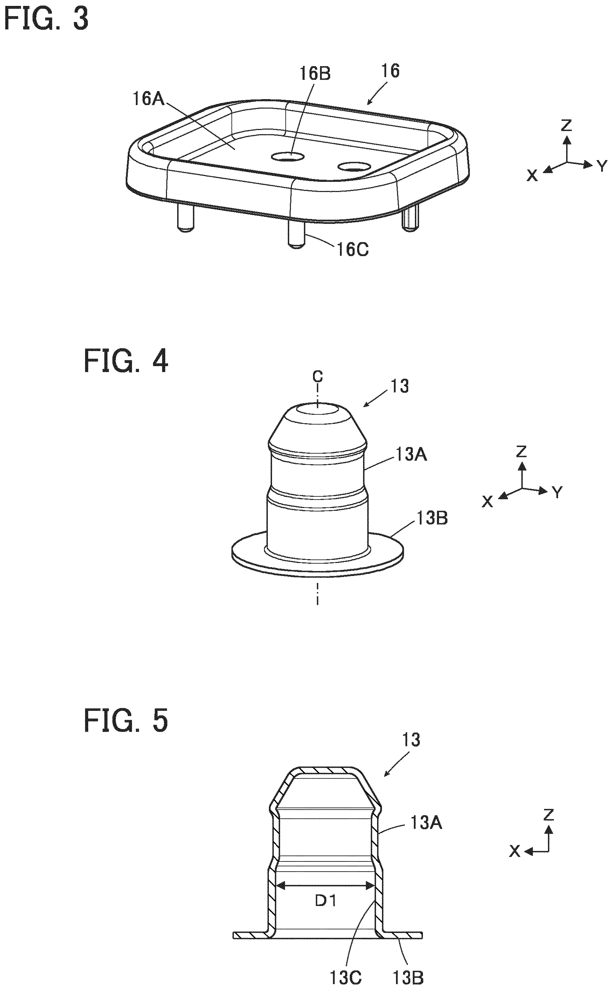

As shown in FIG. 3, the top insulator 16 includes a recessed portion 16A opening in the +Z direction and four contact through-holes 16B formed within the recessed portion 16A. The recessed portion 16A constitutes a counter connector accommodating portion in which part of a counter connector (not shown) is to be accommodated, and the four contact through-holes 16B separately correspond to the four plug contacts 13. In addition, a plurality of bosses 16C protruding in the -Z direction are formed on a surface, facing in the -Z direction, of the top insulator 16.

The four plug contacts 13 are each made of a conductive material such as metal and are to be connected to corresponding contacts of a counter connector (not shown) when part of the counter connector is accommodated in the recessed portion 16A of the top insulator 16.

As shown in FIG. 4, the plug contact 13 includes a tubular portion 13A of cylindrical shape extending in the Z direction along a fitting axis C, and a flange 13B extending from a -Z directional end portion of the tubular portion 13A along an XY plane.

As shown in FIG. 5, the tubular portion 13A is provided in its interior with a recessed portion 13C opening in the -Z direction. The recessed portion 13C has an inside diameter D1 in the vicinity of the -Z directional end portion of the tubular portion 13A.

It should be noted that the fitting axis C is an axis passing the center of the tubular portion 13A and extending in the fitting direction between the connector 11 and a counter connector.

While the tubular portion 13A has a cylindrical shape, the cross-sectional shape thereof is not limited to a circular shape, and the tubular portion 13A may have any of various cross-sectional shapes such as ellipses and polygons as long as the tubular portion 13A is provided in its interior with the recessed portion 13C.

All the four plug contacts 13 can be used as terminals for transmitting electric signals.

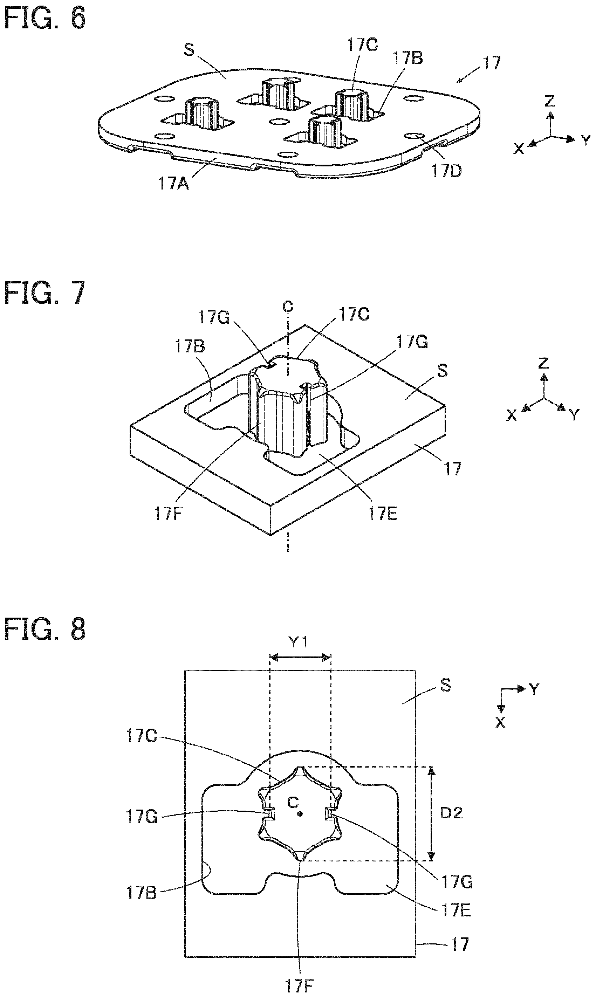

As shown in FIG. 6, the bottom insulator 17 includes a flat plate portion 17A extending along an XY plane, and a surface of the flat plate portion 17A facing in the +Z direction forms a flat placement surface S used to place the sheet type conductive member 15. The placement surface S of the flat plate portion 17A is provided with four recessed shape portions 17B opening in the +Z direction. The four recessed shape portions 17B separately correspond to the four plug contacts 13. The four recessed shape portions 17B are separately provided with four projections 17C projecting from the centers of the recessed shape portions 17B in the +Z direction.

In addition, the flat plate portion 17A is provided with a plurality of through-holes 17D separately corresponding to the plurality of bosses 16C of the top insulator 16.

As shown in FIGS. 7 and 8, the bottom surface of the recessed shape portion 17B of the bottom insulator 17 forms a flat support surface 17E extending along an XY plane and facing in the +Z direction.

The projection 17C projects from the support surface 17E in the +Z direction along the fitting axis C and has a prismatic shape having a substantially hexagonal cross section. The projection 17C is provided, at its lateral surface along the circumference, with six press-fit portions 17F protruding in the radiation direction with the fitting axis C as the center and extending along the fitting axis C.

The projection 17C is also provided at its lateral surface with a pair of insertion grooves 17G separately extending along the fitting axis C in different positions from the press-fit portions 17F. These insertion grooves 17G are used to retain the inner contact 18. One insertion groove 17G opens in the +Y direction, and the other insertion groove 17G opens in the -Y direction.

A distance D2 between a pair of press-fit portions 17F provided in the opposite directions across the fitting axis C is set to be slightly larger than the inside diameter D1 of the recessed portion 13C of the plug contact 13 shown in FIG. 5.

Thus, when the connector 11 is assembled, the plug contact 13 can be fixed to the bottom insulator 17 by press-fitting the projection 17C of the bottom insulator 17 into the recessed portion 13C of the plug contact 13.

Besides, bottoms of the pair of insertion grooves 17G formed at the lateral surface of the projection 17C are separated from each other by a distance Y1 along the Y direction.

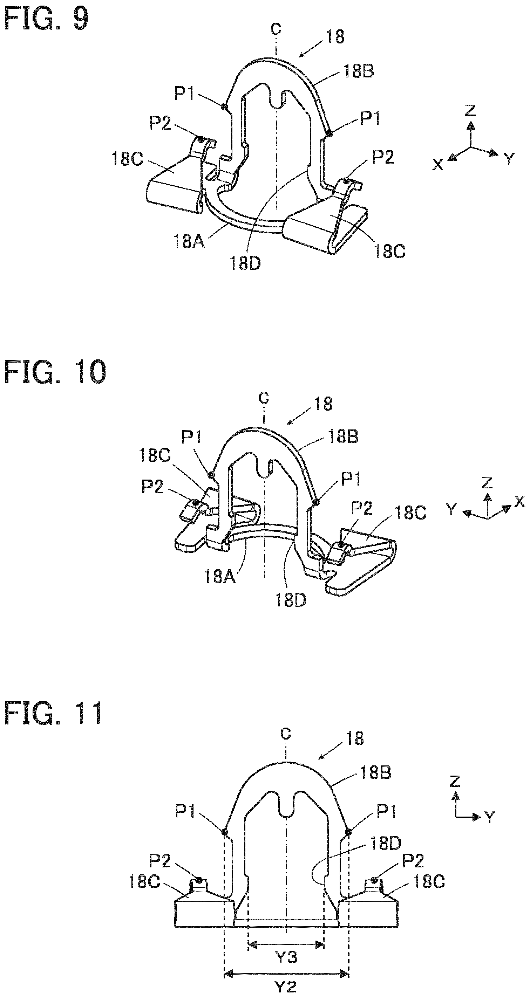

As shown in FIGS. 9 to 10, the inner contact 18 is formed of a single metal sheet having electric conductivity and being bent, and includes a base portion 18A extending along an XY plane, a retention portion 18B joined to the base portion 18A, and a pair of elastic portions 18C joined to the base portion 18A. When the connector 11 has been assembled, the base portion 18A is disposed on the support surface 17E of the corresponding recessed shape portion 17B of the bottom insulator 17, and the retention portion 18B is inserted in the recessed portion 13C of the corresponding plug contact 13.

The base portion 18A is a flat plate member extending in a substantially semicircular form along an XY plane while curving around the fitting axis C. The retention portion 18B is joined to the opposite ends, in the Y direction, of the base portion 18A, and the pair of elastic portions 18C are also joined to the opposite ends, in the Y direction, of the base portion 18A.

The retention portion 18B is a flat member extending along a YZ plane and cut out in a substantially U shape so as to surround the projection 17C of the bottom insulator 17. The retention portion 18B is provided, at its +Y and -Y directional ends at a predetermined height in the Z direction, with a pair of first contact portions P1 that are spaced from each other in the Y direction and face in the opposite directions from each other.

The retention portion 18B also has a pair of pressing portions 18D on the -Z direction side of the pair of first contact portions P1, the pair of pressing portions 18D facing each other across the fitting axis C and protruding toward the fitting axis C. When the connector 11 has been assembled, the projection 17C of the bottom insulator 17 is press-fitted between the pair of pressing portions 18D with the pair of pressing portions 18D being inserted in the pair of insertion grooves 17G of the projection 17C.

The pair of elastic portions 18C each have a cantilever shape that extends in the +X direction from the corresponding Y directional end portion of the base portion 18A, rises in the +Z direction, and is bent to return to the +Z directional side of the corresponding Y directional end portion of the base portion 18A. Because of the shape as above, the pair of elastic portions 18C are each configured to be elastically deformable in the Z direction. The pair of elastic portions 18C are respectively provided at their ends with a pair of second contact portions P2 facing in the +Z direction.

As shown in FIG. 11, a distance Y2 in the Y direction between the pair of first contact portions P1 is set to be slightly larger than the inside diameter D1 of the part of the recessed portion 13C with which the pair of first contact portions P1 make contact when the retention portion 18B is inserted into the recessed portion 13C of the plug contact 13.

Accordingly, the pair of first contact portions P1 make contact with an inner surface of the recessed portion 13C with predetermined contact pressure while being elastically displaced in a direction toward the fitting axis C when the retention portion 18B of the inner contact 18 is inserted into the recessed portion 13C of the plug contact 13.

A distance Y3 in the Y direction between the pair of pressing portions 18D facing each other is set to be slightly smaller than the distance Y1 in the Y direction between the bottoms of the pair of insertion grooves 17G formed at the projection 17C of the bottom insulator 17 shown in FIG. 8.

Accordingly, when the connector 11 is assembled, the inner contact 18 is pushed toward the bottom insulator 17 while the pair of pressing portions 18D of the inner contact 18 is inserted in the pair of insertion grooves 17G of the projection 17C of the bottom insulator 17, whereby the projection 17C is press-fitted between the pair of pressing portions 18D. Hence, the inner contact 18 can be fixed to the bottom insulator 17.

The sheet type conductive member 15 has a multilayer structure in which a plurality of wiring layers each formed from a conductor and a plurality of insulating layers are laminated.

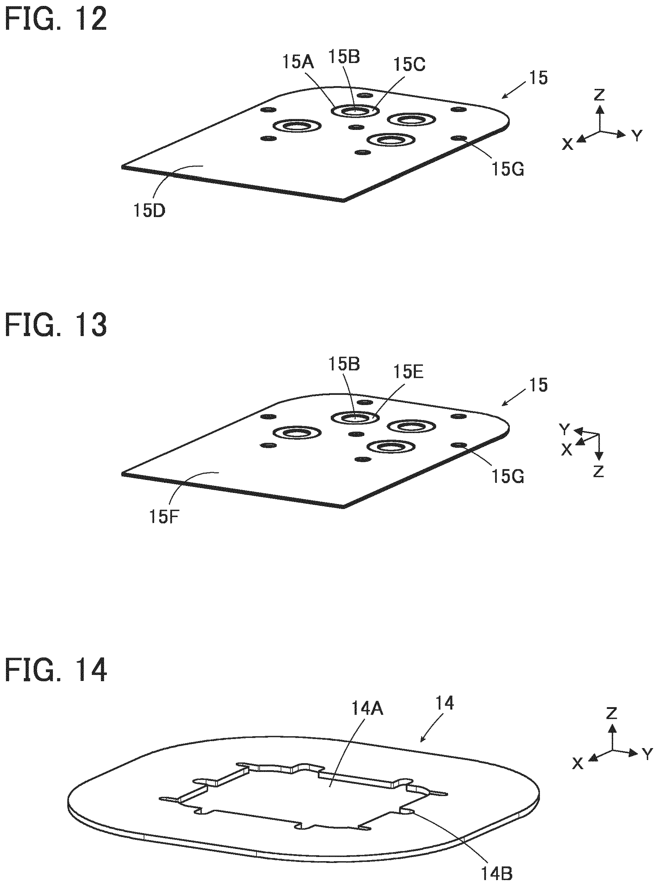

As shown in FIG. 12, four contact arrangement regions 15A for arranging the four plug contacts 13 are defined on the front surface, facing in the +Z direction, of the sheet type conductive member 15. Each contact arrangement region 15A is provided at its central part with a circular opening portion 15B penetrating the sheet type conductive member 15 in the Z direction, and a wiring layer 15C is exposed toward the +Z direction around the opening portion 15B so as to surround the opening portion 15B. An insulating layer 15D is exposed in the other region than the four contact arrangement regions 15A.

Since the opening portions 15B penetrate the sheet type conductive member 15 in the Z direction, as shown in FIG. 13, the opening portions 15B can be seen also on the back surface, facing in the -Z direction, of the sheet type conductive member 15 at positions corresponding to the four contact arrangement regions 15A.

On the back surface, facing in the -Z direction, of the sheet type conductive member 15, a wiring layer 15E is exposed toward the -Z direction around the respective opening portions 15B formed at the positions corresponding to the four contact arrangement regions 15A so as to surround the respective opening portions 15B, and an insulating layer 15F is exposed in the remaining region.

In addition, as shown in FIGS. 12 and 13, a plurality of through-holes 15G separately corresponding to the plurality of bosses 16C of the top insulator 16 are formed in a peripheral portion of the sheet type conductive member 15.

As shown in FIG. 14, the reinforcement sheet 14 is used to reinforce a mounting object (not shown) such as a garment on which the connector 11 is to be mounted. The reinforcement sheet 14 is made of an insulating material and provided at its center with an opening portion 14A. Further, a plurality of cutouts 14B separately corresponding to the plurality of bosses 16C of the top insulator 16 are formed along the circumference of the opening portion 14A of the reinforcement sheet 14.

The four contact through-holes 16B of the top insulator 16, the four plug contacts 13, the four contact arrangement regions 15A of the sheet type conductive member 15, the four inner contacts 18, and the four recessed shape portions 17B of the bottom insulator 17 are arranged to align with each other in the Z direction.

In addition, the bosses 16C of the top insulator 16, the cutouts 14B of the reinforcement sheet 14, the through-holes 15G of the sheet type conductive member 15, and the through-holes 17D of the bottom insulator 17 are arranged to align with each other in the Z direction.

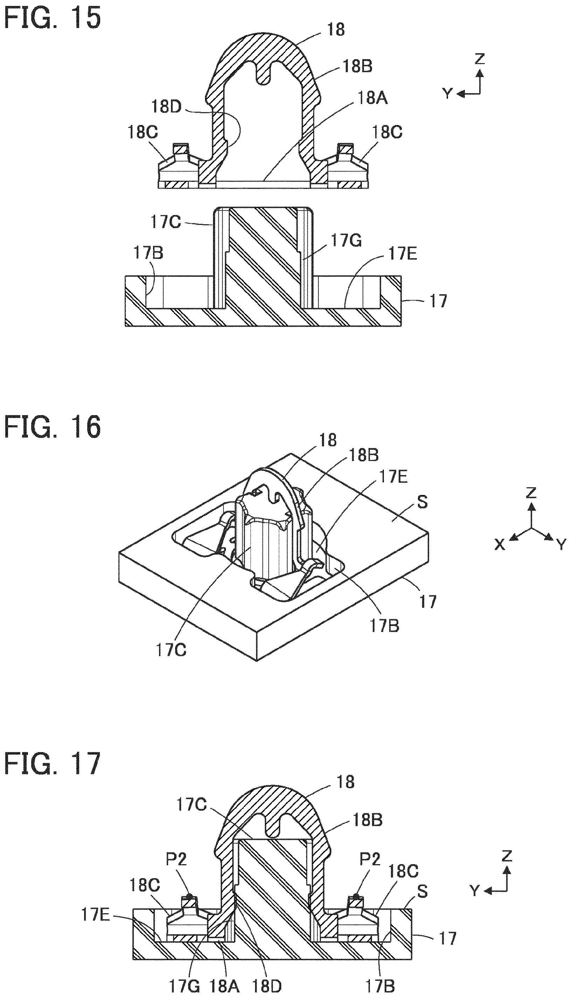

When the connector 11 is assembled, first, the inner contact 18 is positioned with respect to the corresponding recessed shape portion 17B of the bottom insulator 17 on the +Z direction side thereof, as shown in FIG. 15. At this time, the base portion 18A and the pair of elastic portions 18C of the inner contact 18 are situated on the +Z direction side of the corresponding recessed shape portion 17B of the bottom insulator 17, and the retention portion 18B is situated on the +Z direction side of the projection 17C projecting from the recessed shape portion 17B.

Next, the inner contact 18 is pushed in the -Z direction toward the recessed shape portion 17B of the bottom insulator 17, while the projection 17C of the bottom insulator 17 is inserted to the inside of the substantially U-shaped retention portion 18B of the inner contact 18, as shown in FIG. 16. At this time, the inner contact 18 is pushed with the pair of pressing portions 18D projecting toward the inside of the retention portion 18B of the inner contact 18 being inserted in the pair of insertion grooves 17G of the projection 17C of the bottom insulator 17, as shown in FIG. 17.

Since the distance Y3 in the Y direction between the pair of pressing portions 18D of the inner contact 18 shown in FIG. 11 is set to be slightly smaller than the distance Y1 in the Y direction between the bottoms of the pair of insertion grooves 17G of the bottom insulator 17 shown in FIG. 8, when the inner contact 18 is pushed toward the bottom insulator 17, the projection 17C is press-fitted between the pair of pressing portions 18D, so that the inner contact 18 is fixed to the bottom insulator 17.

As shown in FIG. 17, the inner contact 18 is pushed toward the bottom insulator 17 until the base portion 18A and the pair of elastic portions 18C of the inner contact 18 come into contact with the support surface 17E of the recessed shape portion 17B of the bottom insulator 17.

The elastic portions 18C of the inner contact 18 have a Z directional height larger than the depth dimension of the recessed shape portion 17B of the bottom insulator 17, and accordingly, the pair of second contact portions P2 disposed at the ends of the pair of elastic portions 18C protrude in the +Z direction from the recessed shape portion 17B of the bottom insulator 17 and situated on the +Z direction side of the placement surface S of the bottom insulator 17.

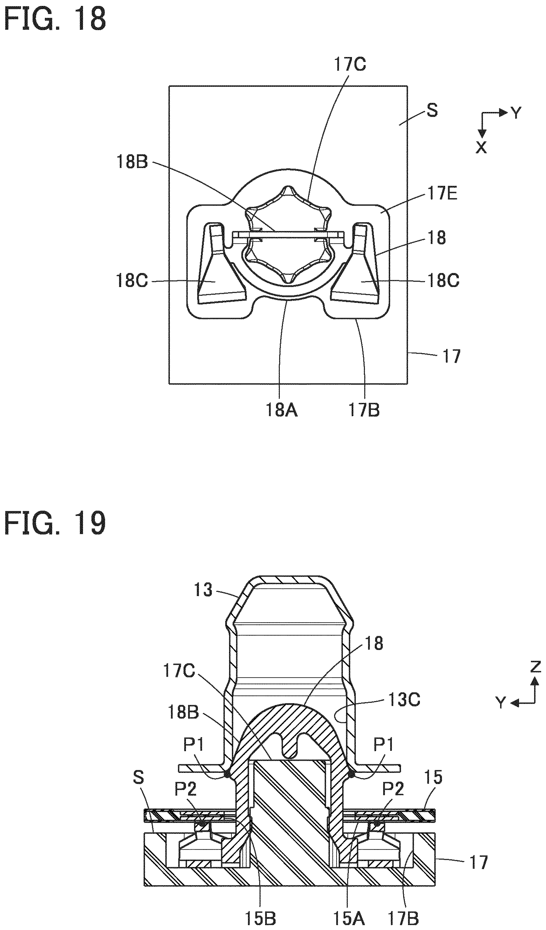

Thus, the inner contact 18 is accommodated in the recessed shape portion 17B of the bottom insulator 17 and supported on the support surface 17E as shown in FIG. 18.

Next, the sheet type conductive member 15 is disposed above the bottom insulator 17 as shown in FIG. 19. At this time, the projection 17C of the bottom insulator 17 and the retention portion 18B of the inner contact 18 fixed to the projection 17C are inserted into the corresponding opening portion 15B of the sheet type conductive member 15, and the contact arrangement region 15A is situated on the +Z direction side of the corresponding recessed shape portion 17B of the bottom insulator 17.

However, since the pair of second contact portions P2 of the inner contact 18 protrude in the +Z direction from the recessed shape portion 17B of the bottom insulator 17 and the sheet type conductive member 15 is situated on the pair of second contact portions P2, the contact arrangement region 15A of the sheet type conductive member 15 is in the state of floating on the +Z direction side of the placement surface S of the bottom insulator 17.

Further, the corresponding plug contact 13 is positioned on the +Z direction side of the sheet type conductive member 15. At this time, the recessed portion 13C of the plug contact 13 is situated on the +Z direction side of the retention portion 18B of the inner contact 18 fixed to the corresponding projection 17C of the bottom insulator 17.

Since the distance Y2 in the Y direction between the pair of first contact portions P1 of the inner contact 18 shown in FIG. 11 is set to be slightly larger than the inside diameter D1 of the recessed portion 13C of the plug contact 13 shown in FIG. 5, the -Z directional end of the recessed portion 13C of the plug contact 13 is caught on the pair of first contact portions P1 as shown in FIG. 19.

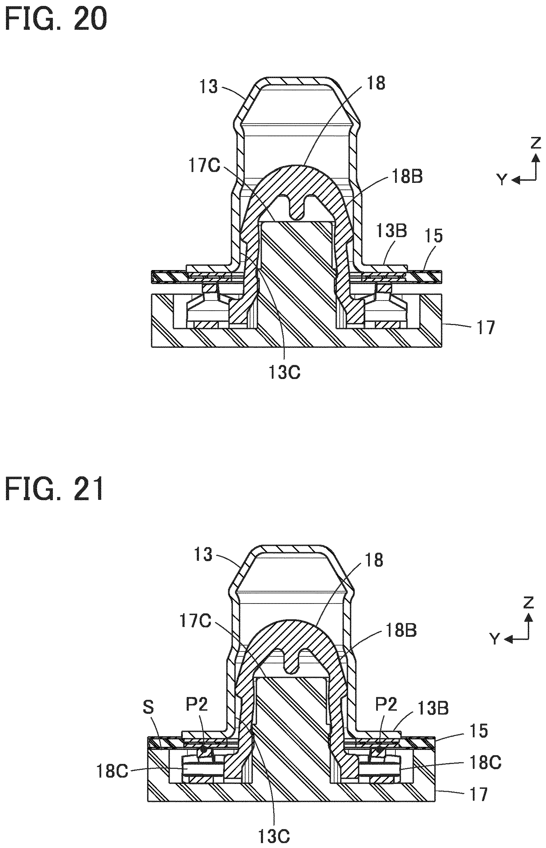

In this state, the plug contact 13 is pushed toward the bottom insulator 17 relatively in the -Z direction. As a consequence, as shown in FIG. 20, the plug contact 13 is moved in the -Z direction while compressing and deforming the retention portion 18B of the inner contact 18 in the Y direction, the retention portion 18B of the inner contact 18 and the projection 17C of the bottom insulator 17 are inserted into the recessed portion 13C of the plug contact 13, and the back surface of the flange 13B of the plug contact 13 makes contact with the front surface, on the +Z direction side, of the sheet type conductive member 15.

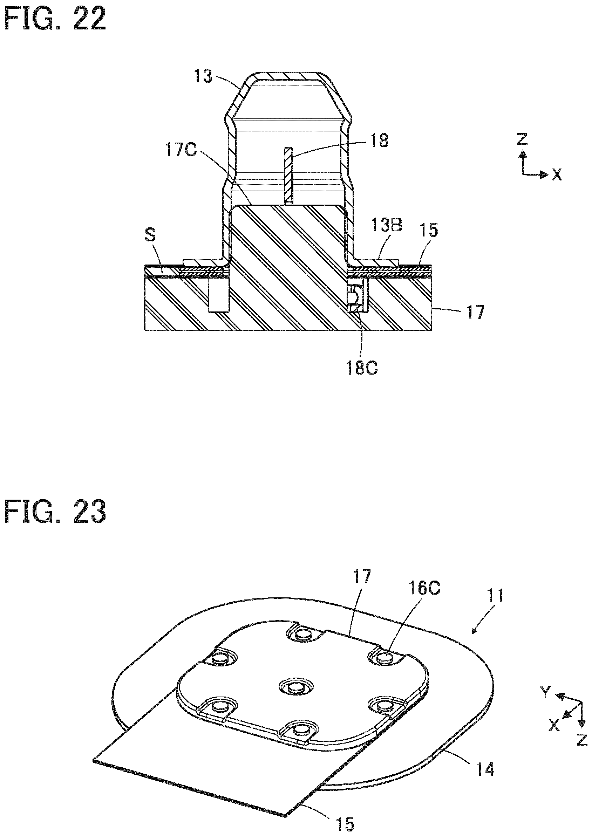

When the plug contact 13 is further pushed in the -Z direction, the sheet type conductive member 15 is pushed in the -Z direction by the flange 13B of the plug contact 13, and the plug contact 13 and the sheet type conductive member 15 are moved in the -Z direction while compressing the pair of elastic portions 18C in the Z direction via the pair of second contact portions P2, whereby the sheet type conductive member 15 makes contact with the placement surface S of the bottom insulator 17, as shown in FIGS. 22 and 23.

Since the distance D2 between the pair of press-fit portions 17F of the projection 17C provided in the opposite directions across the fitting axis C is set to be slightly larger than the inside diameter D1 of the recessed portion 13C of the plug contact 13 as described above, when the plug contact 13 is pushed toward the bottom insulator 17 as shown in FIGS. 19 to 22, the projection 17C is press-fitted into the recessed portion 13C, and the plug contact 13 is fixed to the bottom insulator 17.

In this state, the reinforcement sheet 14 and the top insulator 16 are sequentially disposed with respect to the sheet type conductive member 15 from the +Z direction side. In this process, the tubular portions 13A of the plug contacts 13 are correspondingly inserted into the four contact through holes 16B of the top insulator 16 from the -Z direction, and the bosses 16C of the top insulator 16 sequentially penetrate the cutouts 14B of the reinforcement sheet 14, the through-holes 15G of the sheet type conductive member 15, and the through-holes 17D of the bottom insulator 17. Then, as shown in FIG. 23, the top insulator 16 and the bottom insulator 17 are fixed to each other through heat deformation of the tips of the bosses 16C protruding on the -Z direction side of the bottom insulator 17. Thus, the assembling operation of the connector 11 is completed.

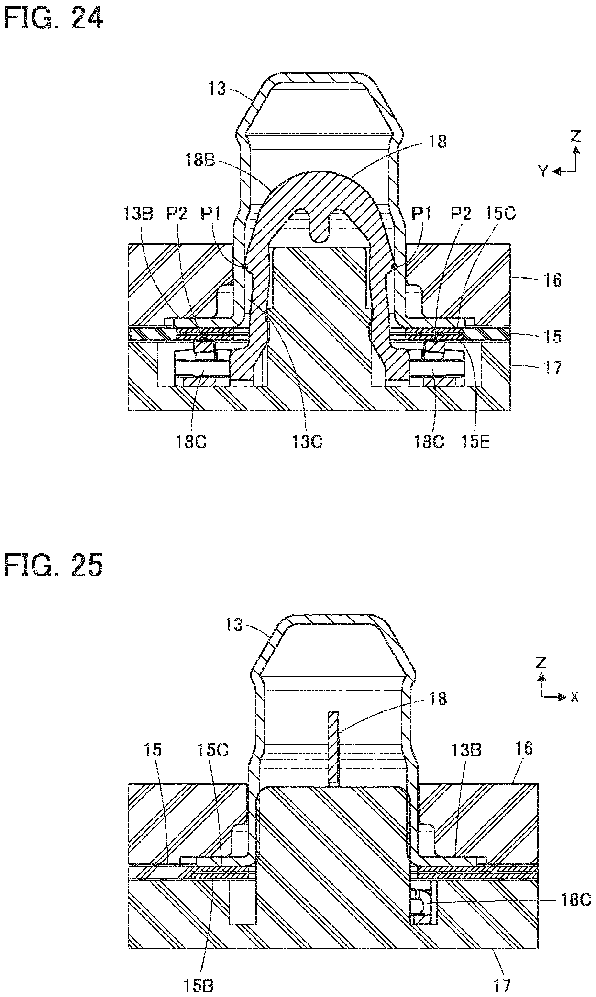

In the thus-assembled connector 11, the sheet type conductive member 15 is sandwiched between the flange 13B of the plug contact 13 and the pair of elastic portions 18C of the inner contact 18 as shown in FIG. 24. In addition, the wiring layer 15C exposed on the front surface, facing in the +Z direction, of the sheet type conductive member 15 faces the back surface of the flange 13B of the plug contact 13, while the wiring layer 15E exposed on the back surface, facing in the -Z direction, of the sheet type conductive member 15 faces the pair of second contact portions P2 of the pair of elastic portions 18C of the inner contact 18.

Consequently, the back surface of the flange 13B of the plug contact 13 makes contact with the wiring layer 15C of the sheet type conductive member 15 with predetermined contact pressure, so that the plug contact 13 is electrically connected to the wiring layer 15C. In addition, the pair of second contact portions P2 of the pair of elastic portions 18C of the inner contact 18 make contact with the wiring layer 15E of the sheet type conductive member 15 with predetermined contact pressure, so that the inner contact 18 is electrically connected to the wiring layer 15E.

When the retention portion 18B of the inner contact 18 is inserted in the recessed portion 13C of the plug contact 13, and the pair of first contact portions P1 formed at the retention portion 18B make contact with the inner surface of the recessed portion 13C of the plug contact 13 with predetermined contact pressure, the inner contact 18 is electrically connected to the plug contact 13.

Therefore, the wiring layer 15C exposed on the front surface of the sheet type conductive member 15 is electrically connected to the plug contact 13 directly, while the wiring layer 15E exposed on the back surface of the sheet type conductive member 15 is electrically connected to the plug contact 13 via the inner contact 18. That is, both the wiring layers 15C and 15E are connected to the plug contact 13.

FIG. 25 is a cross-sectional view of the assembled connector 11 as seen from a direction different from that of FIG. 24, i.e., from a lateral side.

Thus, in the connector 11, the use of the inner contact 18 makes it possible to electrically connect both the wiring layer 15C and the wiring layer 15E respectively formed of conductors disposed on the front surface side and the back surface side of the sheet type conductive member 15 to one plug contact 13.

Therefore, when the connector 11 is connected to a sheet type conductive member having a conductor exposed only on its front surface side, the plug contact 13 can be electrically connected to the conductor on the front surface side of the sheet type conductive member. On the other hand, when the connector 11 is connected to a sheet type conductive member having a conductor exposed only on its back surface side, the plug contact 13 can be electrically connected to the conductor on the back surface side of the sheet type conductive member.

Further, when the connector 11 is connected to a sheet type conductive member having conductors separately exposed on its front surface side and back surface side like the sheet type conductive member 15 in this embodiment, the plug contact 13 can be electrically connected to both the conductors on the front surface side and the back surface side of the sheet type conductive member. For example, assuming that a connection object is a sheet type conductive member having a multilayer structure in which conductors constituting shield layers are separately exposed on the front surface side and the back surface side and a conductor constituting a signal wiring layer is disposed between those shield layers so as to be insulated from both the shield layers, a shield effect is exhibited with respect to the signal wiring layer when the plug contact 13 connected to the shield layers on the front surface side and the back surface side is connected to a ground potential, thus enabling to carry out highly accurate signal transmission with reduced influence of external disturbances caused by, for example, electromagnetic waves.

It should be noted that in the above embodiment, it is not necessary to bend a part of the sheet type conductive member 15 at a substantially right angle to catch and bring it inside the recessed portion 13C of the plug contact 13 like the connector of JP 2018-129244 A shown in FIG. 27; the plug contact 13 can be electrically connected to the wiring layer 15C, 15E of the sheet type conductive member 15 with the sheet type conductive member 15 extending along an XY plane being sandwiched between the flange 13B of the plug contact 13 and the pair of elastic portions 18C of the inner contact 18. Thus, disconnection of the wiring layer 15C, 15E of the sheet type conductive member 15 due to bending can be prevented from occurring, and in addition, the plug contact 13 can be electrically connected to a connection object that is hard to bend.

In the above embodiment, the projection 17C of the bottom insulator 17 is press-fitted into the recessed portion 13C of the tubular portion 13A of the plug contact 13, whereby the plug contact 13 is fixed to the bottom insulator 17. This configuration makes it possible to electrically connect the plug contact 13 to the wiring layer 15C, 15E of the sheet type conductive member 15 without the use of the top insulator 16.

In regard to fixation of the plug contact 13 to the bottom insulator 17, the flange 13B of the plug contact 13 may be held down with the top insulator 16 to fix the plug contact 13 to the bottom insulator 17 by passing the bosses 16C of the top insulator 16 through the through-holes 17D of the bottom insulator 17 and thermally deforming the tips of the bosses 16C or bonding and fixing the top insulator 16 to the bottom insulator 17 with an adhesive.

However, it is difficult to arrange the bosses 16C, which pass through the through-holes 17D, in the vicinity of the plug contact 13 and also difficult to use an adhesive near the plug contact 13 while preventing spreading of the adhesive which may cause poor contact. Accordingly, the top insulator 16 and the bottom insulator 17 may warp due to a reaction force of a contact load in the fitting direction, so that a distance may be increased between the flange 13B of the plug contact 13 and the pair of elastic portions 18C of the inner contact 18, resulting in impaired reliability of the electrical connection.

In contrast, in the above embodiment, the projection 17C of the bottom insulator 17 is press-fitted into the recessed portion 13C of the plug contact 13, whereby the plug contact 13 is fixed to the bottom insulator 17; therefore, the bottom insulator 17 is prevented from warping, thus ensuring the reliability of the electrical connection.

Aside from that, in the above embodiment, the base portion 18A of the inner contact 18 is disposed on the flat support surface 17E that is formed at the bottom surface of the recessed shape portion 17B of the bottom insulator 17 and extends along an XY plane. Owing to this configuration, the inner contact 18 is stably supported inside the connector 11, thus improving the reliability of the electrical connection of the plug contact 13 with the wiring layer 15C, 15E of the sheet type conductive member 15.

While the inner contact 18 has the pair of elastic portions 18C in the above embodiment, the invention is not limited thereto, and the inner contact 18 may have a single elastic portion 18C or three or more elastic portions 18C.

In the above embodiment, the plug contacts 13 disposed in the contact arrangement regions 15A of the sheet type conductive member 15 are connected to both the wiring layer 15C exposed on the front surface side of the sheet type conductive member 15 and the wiring layer 15E exposed on the back surface side of the sheet type conductive member 15; however, for instance, it is also possible to connect only the wiring layer 15E exposed on the back surface side of the sheet type conductive member 15 to the plug contacts 13 disposed in the contact arrangement regions 15A.

While the sheet type conductive member 15 used in the above embodiment has a multilayer structure, the invention is not limited thereto, and it suffices if a conductive member has a conductor exposed on at least one surface.

In addition, while two layers of the conductors, i.e., the wiring layer 15C and the wiring layer 15E of the sheet type conductive member 15 are connected to one plug contact 13 in the above embodiment, the invention is not limited thereto, and three or more layers of conductors may be connected to one plug contact 13.

In addition, while the connector 11 in the above embodiment has the four plug contacts 13, the invention is not limited to this number of the plug contacts 13, and it suffices if the connector includes at least one plug contact 13 electrically connected to a conductor exposed on at least one surface of the sheet type conductive member 15.

While the reinforcement sheet 14 is disposed between the bottom insulator 17 and the top insulator 16 in the above embodiment, the reinforcement sheet 14 may be omitted when it is not necessary to reinforce a mounting object such as a garment to which the connector 11 is to be attached.

## Claims

1. A connector comprising:
a plug contact (13) having electric conductivity and including a tubular portion (13A) and a flange (13B), the tubular portion extending along a fitting axis (C) and being provided in its interior with a recessed portion (13C), and the flange extending from an end portion of the tubular portion in a direction orthogonal to the fitting axis;
a bottom insulator (17) including a support surface (17E) and a projection (17C), the support surface extending in the direction orthogonal to the fitting axis, and the projection projecting from the support surface along the fitting axis and being press-fitted in the recessed portion; and
an inner contact (18) having electric conductivity and being disposed on the support surface, part of the inner contact being inserted in the recessed portion,
wherein the inner contact (18) includes a retention portion (18B) and an elastic portion (18C), the retention portion being retained in the recessed portion and making contact with an inner surface of the recessed portion to be electrically connected to the plug contact, and the elastic portion being joined to the retention portion to face a back surface of the flange and having a cantilever shape that is elastically deformable in a direction along the fitting axis,
when the projection is press-fitted in the recessed portion, the plug contact is fixed to the bottom insulator, and
part of a connection object (15) of sheet shape having a conductor (15C, 15E) exposed on at least one surface of the connection object is sandwiched between the back surface of the flange of the plug contact and the elastic portion of the inner contact in a direction along the fitting axis, the back surface of the flange makes contact with a front surface of the connection object, and the elastic portion makes contact with a back surface of the connection object, whereby the plug contact is electrically connected to the conductor directly when the conductor (15C) is exposed on the front surface of the connection object, and the plug contact is electrically connected to the conductor via the inner contact when the conductor (15E) is exposed on the back surface of the connection object.

2. The connector according to claim 1,
wherein the inner contact (18) is formed of a metal sheet being bent and includes:
a base portion (18A) of flat plate shape extending in th direction orthogonal to the fitting axis and being disposed on the support surface;
the retention portion (18B) of flat plate shape being joined to the base portion and being cut out in a U shape so as to surround the projection along a plane including the fitting axis; and
a pair of elastic portions (18C) each identical to the elastic portion, the pair of elastic portions being joined to the base portion and disposed at positions facing each other across the fitting axis.

3. The connector according to claim 2,
wherein the retention portion (18B) has a pair of first contact portions (P1) that are spaced from each other in the direction orthogonal to the fitting axis and separately make contact with the inner surface of the recessed portion, and
the pair of elastic portions (18C) have a pair of second contact portions (P2) disposed at ends of the pair of elastic portions, respectively.

4. The connector according to claim 3,
wherein the retention portion (18B) includes a pair of pressing portions (18D) facing each other across the fitting axis and separately protruding in directions toward the fitting axis, and
the projection is press-fitted between the pair of pressing portions, whereby the inner contact is retained by the bottom insulator.

5. The connector according to claim 4,
wherein the projection (17C) includes a pair of insertion grooves (17G) in which the pair of pressing portions are inserted.

6. The connector according to any one of claims 1-5,
wherein the projection (17C) includes a plurality of press-fit portions (17F) that protrude in a radiation direction with the fitting axis as a center from a lateral surface of the projection extending along a circumference of the projection and that extend along the fitting axis, and
the plurality of press-fit portions are press-fitted in the recessed portion.

7. The connector according to any one of claims 1-6,
wherein the bottom insulator (17) includes a placement surface (S) which extends in the direction orthogonal to the fitting axis and on which the connection object is placed, and
the support surface is constituted of a bottom surface of a recessed shape portion (17B) formed at the placement surface.

8. The connector according to any one of claims 1-7, comprising a top insulator (16) being provided with a contact through-hole (16B) through which the tubular portion of the plug contact passes and which is smaller than the flange,
wherein the top insulator is fixed to the bottom insulator such that the tubular portion of the plug contact passes through the contact through-hole and that the flange of the plug contact, the connection object, and the elastic portion of the inner contact are sandwiched between the top insulator and the bottom insulator.
